# FASCICULE DE BREVET EUROPEEN

(11) **EP 1 293 112 B1**
(45) Date de publication et mention de la délivrance du brevet: **10.06.2009**
(21) Numéro de dépôt: 01947550.8
(22) Date de dépôt: 20.06.2001
(51) Int. Cl.: H05K 7/20

(54) **MONITEUR D'AFFICHAGE INSTALLE DANS UN BOÎTIER D'HABILLAGE CONSTITUANT UN CONFINEMENT**
IN EIN ELEKTRONISCHES GEHÄUSE MIT BEHÄLTER EINGEBAUTER ANZEIGEMONITOR
DISPLAY MONITOR INSTALLED IN A PROTECTIVE HOUSING FORMING A CONFINEMENT

(30) Priorité: 23.06.2000 FR 0008259
(43) Date de publication de la demande: 19.03.2003
(73) Titulaire: Atuser SARL, 92200 Neuilly sur Seine (FR)
(72) Inventeur: MULLERIS, Jean-Jacques, F-92200 Neuilly sur Seine (FR)
(74) Mandataire: Debay, Yves
(86) Numéro de dépôt international: PCT/FR2001/001936
(87) Numéro de publication internationale: WO 2001/099482

(56) Documents cités:
- US-A- 5 321 581
- US-A- 5 493 473
- US-A- 5 743 794
- US-A- 5 801 792

## Description

La présente invention concerne un moniteur d'affichage installé dans un boîtier d'habillage constituant un confinement. Le moniteur d'affichage peut comprendre tous moyens d'affichage d'informations digitales tels qu'un écran à plasma, un écran TFT, un écran CRT, un écran LCD ou tout autre écran numérique.

Il est connu dans l'art antérieur des panneaux d'affichage à écran plasma dont le volume occupé est important. En effet, le boîtier qui contient ces écrans doit également comporter l'alimentation vidéo de l'écran. Ces écrans présentent par ailleurs le désavantage de dégager de la chaleur, ce qui les soumet à un échauffement. Ils ne peuvent donc être logés dans des espaces confinés tels que du mobilier ou des boîtiers d'affichage à espace réduit.

La présente invention a donc pour objet de pallier les inconvénients de l'art antérieur en proposant un caisson éventuellement contenu dans un boîtier d'affichage et comprenant un écran et éventuellement un dispositif d'alimentation comprenant notamment, l'alimentation vidéo. L'alimentation vidéo à écran plasma, est reliée par un flexible qui contient les fils conducteurs. Le volume et l'encombrement du boîtier d'affichage se trouvent donc réduits par rapport au volume et à l'encombrement d'un moniteur d'affichage à écran plasma selon l'art antérieur. L'invention propose par ailleurs un dispositif de refroidissement du boîtier d'affichage contenant l'écran plasma.

L'objet de l'invention est atteint pour un moniteur d'affichage comprenant des moyens de visualisation digitaux selon les revendications 1 et 12. Les modes particuliers de réalisation de l'invention sont décris dans les revendications 2-11.

Selon un aspect de l'invention, le dispositif de refroidissement est un dispositif de refroidissement par ventilation forcée. Ce dispositif comprend un circuit de ventilation qui permet la circulation d'air autour de l'écran plasma. L'air est fourni par un dispositif d'aspiration d'air, pour être ensuite rejeté à l'extérieur par un dispositif de refoulement d'air.

Selon un aspect de l'invention, le dispositif d'aspiration d'air et le dispositif de refoulement d'air du dispositif de refroidissement sont logés avec le dispositif d'alimentation dans le boîtier de ventilation.

Le circuit de circulation d'air parcourt un trajet derrière l'écran plasma dans le caisson. L'arrivée d'air du circuit de circulation d'air du caisson est reliée par un premier flexible au dispositif d'aspiration d'air logé dans le boîtier d'alimentation. La sortie d'air du circuit de circulation d'air du boîtier d'affichage est reliée par un second flexible au dispositif de refoulement d'air logé dans le boîtier de ventilation.

Selon un aspect de l'invention, le caisson est creux et comprend une cloison séparatrice qui sépare l'arrivée d'air au caisson de la sortie d'air du caisson, de façon à former un circuit de canalisation de l'air qui circule derrière l'écran plasma.

Selon un aspect de l'invention, l'épaisseur du caisson est d'environ 85 mm et l'épaisseur de l'écran plasma logé dans le caisson est d'environ 65 mm.

L'invention, avec ses caractéristiques et avantages, ressortira plus clairement à la lecture de la description faite en référence aux dessins annexés dans lesquels:
- la figure 1 représente une vue d'un moniteur d'affichage avec un dispositif d'alimentation déporté conforme à l'idée de l'invention
- les figures 2A à 2C représentent respectivement une vue de face, une vue de dessus et une vue de côté du caisson intégré dans un meuble ou boîtier d'affichage,
- la figure 3 représente une vue de face du boîtier de ventilation intégrant le dispositif d'alimentation du moniteur ;
- les figures 4A et 4B représentent une autre variante de réalisation d'un moniteur d'affichage avec un dispositif d'alimentation déporté conforme à l'idée de l'invention ;
- les figures 5A et 5B représentent deux variantes de réalisation d'un moniteur d'affichage avec dispositif d'alimentation intégré conforme à l'idée de l'invention.

Les figures représentent une variante de réalisation du moniteur d'affichage selon l'invention dans laquelle les moyens de visualisation comprennent un écran à plasma. Cependant, d'autres moyens de visualisation digitaux, tels qu'un écran TFT, un écran CRT, un écran LCD ou tout autre écran numérique, peuvent être implantés dans le moniteur d'affichage selon l'invention, à la place de l'écran à plasma décrit par la suite.

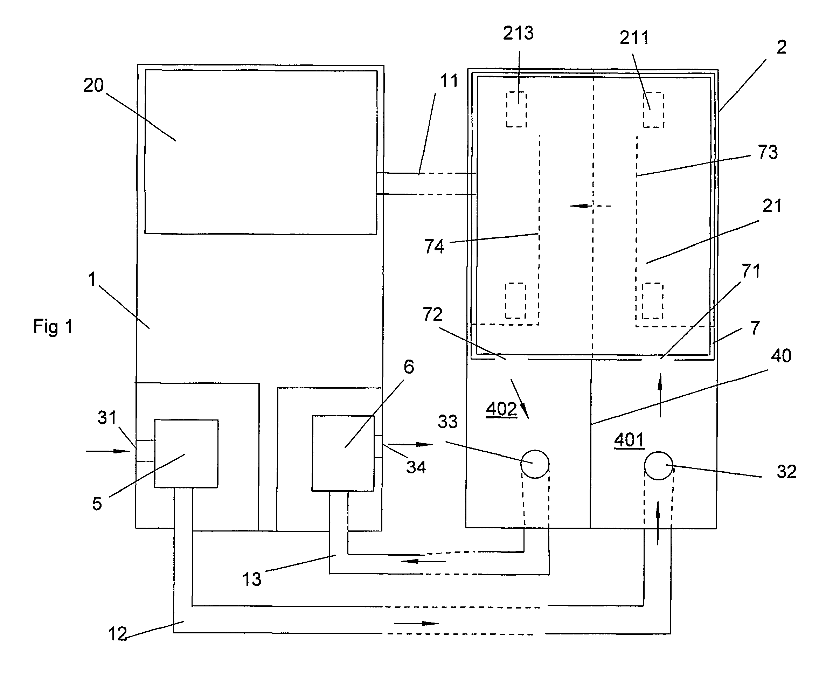

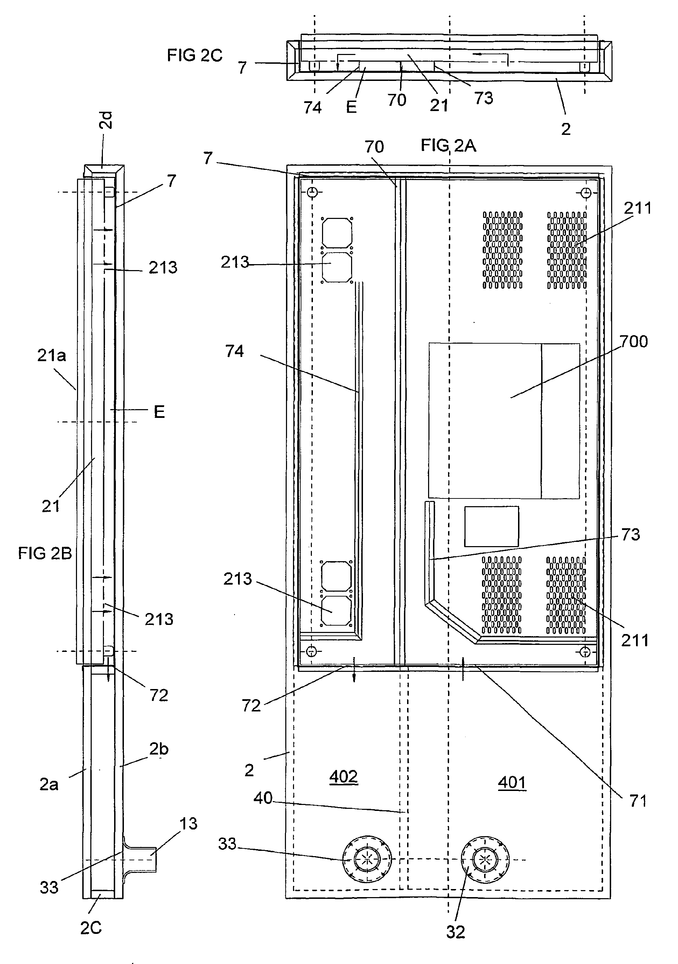

Le moniteur d'affichage selon l'invention va à présent être décrit en référence aux figures 1 et 2A à 2C. Selon la variante de réalisation représentée à la figure 1, le moniteur d'affichage comprend un boîtier de ventilation (1) et un boîtier d'affichage (2) distinct du boîtier de ventilation (1). Le boîtier de ventilation (1) comprend, notamment, le dispositif d'alimentation vidéo (20) de l'écran plasma (21). L'écran plasma (21) est logé dans un caisson (7, fig. 2A à 2C), lui-même solidaire du boîtier d'affichage (2). L'écran (21) à plasma comprend de manière connue un châssis percé d'ouvertures (211, 213) d'aération permettant la circulation d'air à l'intérieur du châssis pour refroidir l'écran (21) à plasma.

Le dispositif d'alimentation vidéo (20) est relié par le flexible (11) qui contient des fils conducteurs de connexion à l'écran plasma (21) fournissant les tensions d'alimentation et les données de commande. Le boîtier de ventilation (1) comprend également un dispositif d'aspiration d'air (5) qui aspire l'air extérieur à travers la bouche d'aspiration d'air (31) disposée dans le boîtier de ventilation (1). Ce dispositif d'aspiration d'air (5), qui peut, par exemple, être une turbine, envoie l'air dans le flexible d'entrée d'air (12) reliant le dispositif d'aspiration d'air (5) du boîtier de ventilation (1) à une bouche d'entrée d'air (32) du boîtier d'affichage (2). Le boîtier de ventilation (1) comprend également un dispositif de refoulement d'air (6) qui refoule l'air de retour du boîtier d'affichage (2) vers l'extérieur au travers de la bouche de refoulement (34) disposée dans le boîtier de ventilation (1). Ce dispositif de refoulement d'air (6), qui peut, par exemple, être une turbine, aspire l'air dans le flexible de sortie d'air (13) qui relie la bouche de sortie d'air (33) du boîtier d'affichage (2) au dispositif de refoulement d'air (6) du boîtier de ventilation (1).

Le boîtier (2) d'affichage comprend également une cloison (40) permettant de délimiter deux volumes (401, 402) à l'intérieur du boîtier (2) d'affichage. Selon l'invention, la bouche (32) d'entrée d'air du boîtier (2) d'affichage débouche dans un premier volume (401) et la bouche (33) de sortie d'air débouche dans le deuxième volume (402) du boîtier (2) d'affichage. Ainsi, la cloison (40) permet d'empêcher le mélange entre l'air frais arrivant par la bouche (32) d'entrée du boîtier (2) d'affichage et l'air réchauffé sortant par la bouche (33) de sortie du boîtier (2) d'affichage.

En référence aux figures 2A à 2C, représentant une variante de réalisation dans laquelle le dispositif d'alimentation du moniteur est déporté, le caisson (7) est de forme complémentaire à la forme de l'écran (21) à plasma, de sorte que ce dernier s'encastre dans le caisson (7) par la face avant du caisson (7). De même, les dimensions du caisson (7), et notamment la profondeur du caisson (7), sont choisies pour qu'un espace (E), suffisant pour permettre la circulation d'air, existe entre le fond du caisson (7) et l'arrière de l'écran (21) à plasma. Ainsi, l'air présent dans cette espace peut entrer dans l'écran (21) à plasma par les ouvertures d'aération. Le caisson (7) comprend sur un côté, une première ouverture (71) permettant l'entrée d'un flux d'air forcé généré par le dispositif (5) d'aspiration d'air du boîtier de ventilation. Lorsque, le caisson (7) est monté dans le boîtier d'affichage, la première ouverture (71) est placée dans le premier volume (401) du boîtier d'affichage. Le caisson (7) comprend également, par exemple, sur le même côté, une deuxième ouverture (72) permettant la sortie d'un flux d'air forcé généré par le dispositif (6) de refoulement d'air du boîtier de ventilation. Lorsque, le caisson (7) est monté dans le boîtier d'affichage, la deuxième ouverture (72) est placée dans le deuxième volume (402) du boîtier (2) d'affichage.

Pour empêcher le mélange de l'air frais arrivant par la première (71) ouverture avec l'air réchauffé sortant par la deuxième (72) ouverture, le caisson (7) peut comprendre au moins une cloison (70, 73, 74) fixée, d'une part sur le fond du caisson (7) et d'autre part sur l'arrière de l'écran (21) à plasma. Une première cloison (70) du caisson est, par exemple, placée de sorte que la première ouverture (71) soit située d'un côté de la cloison et que la deuxième ouverture (72) soit située de l'autre côté de la cloison (70). De même, la première cloison (70) du caisson (7) est disposée de sorte que des ouvertures (211, 213) d'aération de l'écran (21) à plasma soient placées de part et d'autre de la première cloison (70). Dans chaque compartiment du caisson (7) délimité par la première cloison (70), une deuxième (73) et troisième cloisons (74) peuvent être mises en place. Une deuxième cloison (73) est disposée dans le compartiment d'arrivée d'air frais et a pour fonction de guider et d'orienter l'air frais vers la partie haute des moyens (21) de visualisation, c'est-à-dire vers les points les plus chauds des moyens (21) de visualisation. Ainsi, l'air le plus frais refroidit les éléments les plus chauds puis les moins chauds. Dans l'exemple de réalisation représenté à la figure 2A, la face arrière de l'écran plasma comprend un bossage (700) situé dans le compartiment d'air frais. Selon ce mode de réalisation, la deuxième cloison (73) comprend une portion parallèle à la première cloison (70) et placée dans le prolongement du bossage (700). Ainsi, l'air frais arrivant par la première ouverture du caisson (7) est guidé vers les endroits les plus chauds, entre la première cloison (70) et la deuxième cloison (73) puis entre la première cloison (70) et le bossage (700). Lorsque l'écran (21) plasma ne comprend pas de bossage (700) sur la face arrière, la portion de la deuxième cloison (73) parallèle à la première cloison (70) peut se prolonger sur une longueur correspondant à la longueur du bossage (700).

Une troisième cloison (74) est disposée dans le compartiment de refoulement d'air chaud et a pour fonction d'assurer un refoulement ou une aspiration plus importante de l'air le plus réchauffé vers la deuxième (72) ouverture du caisson (7) en guidant et orientant l'air réchauffé.

Le circuit de l'air est donc le suivant : l'air est aspiré au travers de la bouche d'aspiration (31) par le dispositif d'aspiration d'air (5), il circule dans le flexible d'entrée d'air (12) pour pénétrer dans le premier (401) volume du boîtier d'affichage (2) au travers de la bouche d'entrée d'air (32). L'air frais entre ensuite dans le caisson (7) par la première ouverture (71) du caisson (7). L'air est ensuite guidé vers le haut de l'écran plasma, c'est-à-dire vers la partie la plus chaude, par la deuxième cloison (73). L'air circule ensuite dans l'écran plasma (21) en entrant par des premières ouvertures (211) d'aération, disposées du côté de la cloison (70) du caisson (7) dans lequel la première ouverture (71) débouche. Après avoir refroidi l'écran (21) à plasma, l'air réchauffé sort de l'écran (21) à plasma par des deuxièmes ouvertures (213) d'aération disposées du côté de la cloison (70) du caisson (7) dans lequel la deuxième ouverture (72) débouche. L'air réchauffé est ensuite aspiré dans le deuxième volume (402) du boîtier (2) d'affichage au travers de la bouche de sortie d'air (33). Afin que l'air le plus réchauffé, c'est-à-dire l'air débouchant en haut de l'écran (21), soit aspiré plus rapidement que l'air le moins réchauffé, c'est-à-dire l'air débouchant en bas de l'écran (21), la troisième cloison (74) force l'air débouchant dans le bas de l'écran (21) plasma à remonter vers le haut.

L'air réchauffé circule ensuite dans le flexible de sortie d'air (13) pour être aspiré par le dispositif de refoulement (6) puis refoulé à l'extérieur du boîtier de ventilation (1) au travers de la bouche de refoulement (34).

Les figures 2A à 2C représentent différentes vues du boîtier d'affichage (2). Le boîtier d'affichage (2) comporte une première face (2a) qui est exposée à la vue de l'utilisateur et une seconde face (2b), opposée à la première face (2a), sur laquelle est disposée la bouche d'entrée d'air (32) non visible et la bouche de sortie d'air (33). La bouche d'arrivée d'air (32) et la bouche de sortie d'air (33) sont disposées à proximité d'une première face latérale (2c) du boîtier d'affichage (2). La cloison (40) disposée à l'intérieur du boîtier creux d'affichage (2) forme une séparation pour la circulation de l'air dans le boîtier (2) d'affichage. Le boîtier d'affichage (2) présente par ailleurs une découpe sur sa première face (2a) de même périmètre que le périmètre extérieur du caisson (7). Le caisson (7) est logé à l'intérieur du boîtier d'affichage (2) de sorte que la face visible (21 a) de l'écran plasma (21) soit disposée à ras de la première face (2a) du boîtier d'affichage (2). La hauteur de l'écran plasma (21) est inférieure à la hauteur du boîtier d'affichage (2). La circulation de l'air provenant de la bouche d'entrée d'air (32) entre dans le premier volume (401) délimité par la cloison (40) et sort par la bouche de sortie d'air (33) pour refroidir l'écran plasma (21) en circulant dans le caisson (7) puis à l'intérieur de l'écran (21) à plasma.

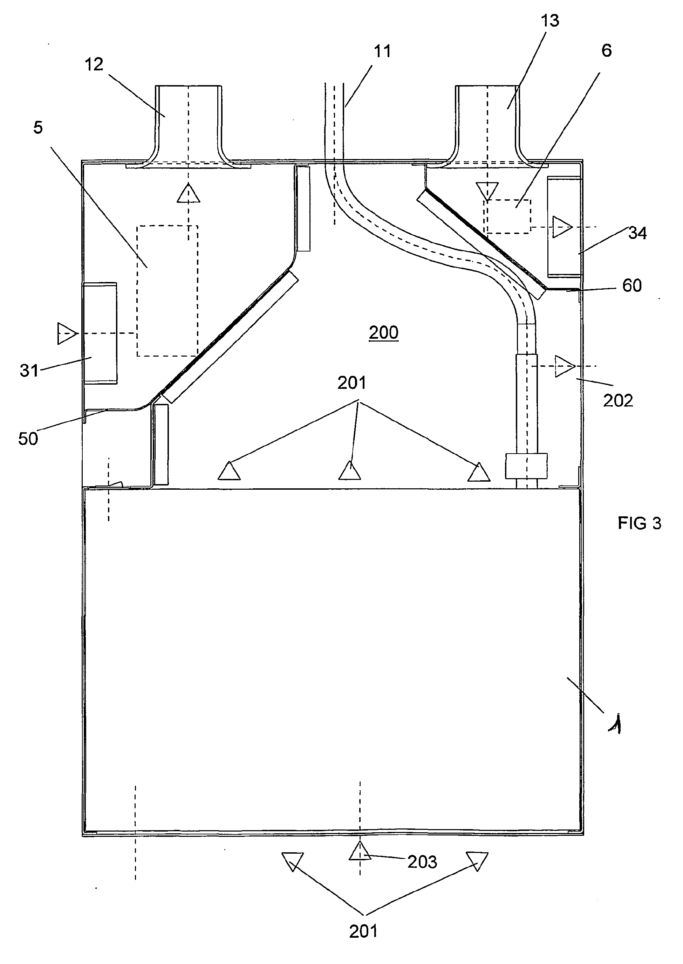

Le boîtier (1) de ventilation va à présent être décrit en référence à la figure 3. Comme décrit précédemment, le boîtier (1) de ventitation comprend à la fois la source d'alimentation vidéo et la source d'alimentation électrique de l'écran à plasma. Dans la variante de réalisation représentée sur la figure 3, le boîtier (1) de ventilation comprend également les moyens de création du flux d'air forcé permettant de refroidir efficacement l'écran à plasma. Le boîtier (1) de ventilation comprend une pluralité de compartiments (50, 60, 200) isolés les uns des autres. Un premier compartiment (50) est destiné au montage des moyens (5) d'aspiration de l'air et comprend par conséquent, la turbine (5), le flexible (12) de connexion entre le boîtier (1) de ventilation et la bouche (32, fig. 1) d'entrée d'air du boîtier (2) d'affichage, et la bouche (31) d'aspiration d'air du boîtier (1) de ventilation. Un deuxième compartiment (60) est destiné au montage des moyens (6) de refoulement de l'air et comprend par conséquent, la turbine (6), le flexible (13) de connexion entre le boîtier (1) de ventilation et la bouche (33, fig. 1) de sortie d'air du boîtier (2) d'affichage, et la bouche (34) de refoulement du boîtier (1) de ventilation. Un troisième compartiment (200) comprend le dispositif (20) d'alimentation électrique et des moyens (201 à 203) de refroidissement de ce dispositif. Les moyens (201 à 203) de refroidissement comprennent, par exemple, au moins une turbine (203) d'aspiration permettant d'aspirer de l'air frais à l'intérieur des moyens (20) d'alimentation électrique.

Dans une autre variante de réalisation, les moyens d'aspiration (5) d'air comprennent des moyens de réfrigération de l'air envoyé dans le caisson (7). Ainsi, l'efficacité de refroidissement de l'écran est améliorée grâce à l'effet Peltier.

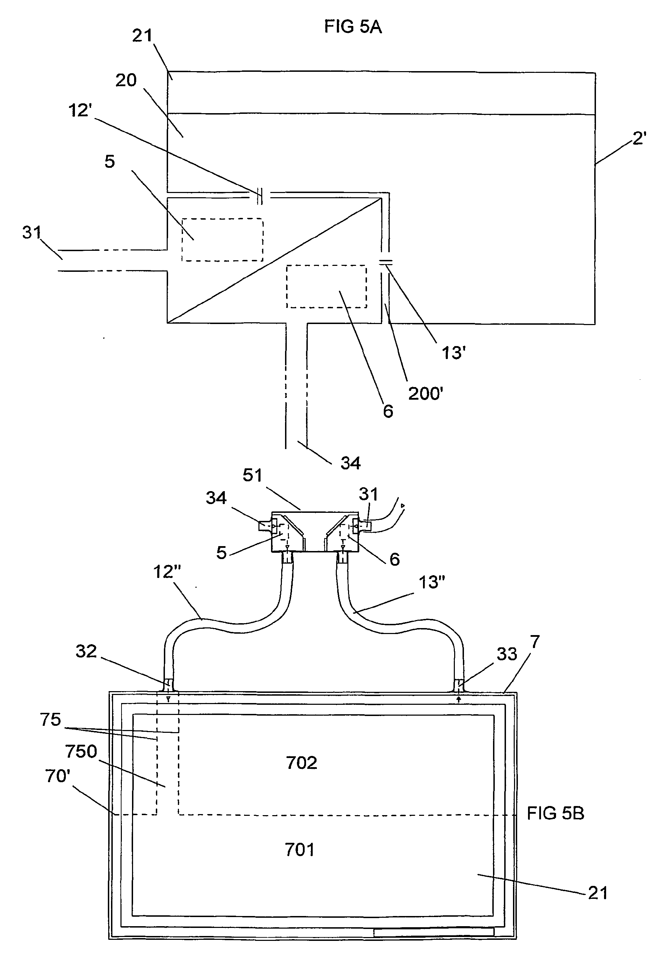

Les figures 5A et 5B représentent deux variantes de réalisation d'un moniteur d'affichage conforme à l'idée de l'invention. Dans ces deux variantes, les éléments matériels sont sensiblement les mêmes en termes de fonction que ceux de la variante de réalisation représentée à la figure 1. Les différences entre ces deux variantes de réalisation et la variante de réalisation représentée à la figure 1 résident dans la disposition des différents éléments.

Dans les deux variantes de réalisation, les moyens de visualisation (21) et le dispositif d'alimentation sont disposés dans un même boîtier (2') d'habillage. Dans la variante de réalisation représentée à la figure 5A, le boîtier (2') d'habillage, comprend un espace ou un logement (200') permettant de mettre en place les moyens (5, 6) de création d'un flux d'air forcé. Ces moyens de création d'un flux d'air forcé comprennent le dispositif d'aspiration (5) et le dispositif de refoulement (6).

Le dispositif d'aspiration (5) est connecté par un conduit (12') à une ouverture d'aération du boîtier (2') d'habillage, La bouche (31) d'aspiration d'air frais du dispositif (5) d'aspiration comprend un flexible dont l'extrémité libre est située dans un lieu déporté par rapport au boîtier (2') d'habillage. Ce lieu déporté est choisi de sorte que son volume et le débit d'air frais du dispositif (5) d'aspiration soit suffisant pour refroidir les moyens de visualisation (21) et le dispositif (20) d'alimentation.

Le dispositif (6) de refoulement est connecté par un conduit (13') à une ouverture d'aération du boîtier (2') d'habillage. La bouche (34) de refoulement d'air chaud du dispositif (6) de refoulement comprend un flexible dont l'extrémité libre est située dans un lieu déporté par rapport au boîtier (2') d'habillage. Ce lieu déporté est choisi de sorte que son volume ainsi que le refoulement de l'air chaud du dispositif (5) de refoulement soit suffisant pour refroidir les moyens de visualisation (21) et le dispositif (20) d'alimentation. De même que pour la variante de réalisation décrite en référence aux figures 1, 2A à 2C et 3, des moyens de réfrigération de l'air peuvent être mis en place, soit au niveau du logement du boîtier, soit dans le lieu déporté, par exemple à l'extrémité libre du flexible d'aspiration.

Dans la variante de réalisation représentée à la figure 5B, le boîtier d'habillage comprend à la fois, les moyens de visualisation (21) et le dispositif d'alimentation du moniteur. Les moyens (5, 6) de création d'un circuit d'air forcé sont déportés.

Ainsi, le dispositif d'aspiration (5) est connecté par un conduit (12") à une ouverture d'aération des moyens de visualisation (21) d'affichage. De même, le dispositif (5) d'aspiration est situé dans un lieu déporté par rapport au boîtier (2') d'habillage. Ce lieu déporté est choisi de sorte que son volume ainsi que le débit d'air frais du dispositif (5) d'aspiration soient suffisants pour refroidir les moyens de visualisation (21) et le dispositif (20) d'alimentation.

Le dispositif (6) de refoulement est connecté par un conduit (13") à une ouverture d'aération des moyens de visualisation (21). De même, le dispositif (6) de refoulement est situé dans un lieu déporté par rapport au boîtier (2') d'habillage. Ce lieu déporté est choisi de sorte que son volume ainsi que le refoulement de l'air chaud du dispositif (5) de refoulement soient suffisants pour refroidir les moyens de visualisation (21) et le dispositif (20) d'alimentation.

Dans cette variante de réalisation, le dispositif (5) d'aspiration et le dispositif (6) de refoulement sont montés dans un même boîtier (51). Le caisson (7) dans lequel sont montés les moyens de visualisation (21) comprend, comme décrit précédemment une bouche (32) d'arrivée d'air et une bouche (33) de sortie d'air. Le caisson (7) comprend également une pluralité de cloisons (70', 75) permettant d'une part d'empêcher le mélange du flux d'air frais et du flux d'air réchauffé et d'autre part de guider l'air frais vers les endroits les plus chauds ou vers les ouvertures d'aération des moyens d'affichage par lesquelles l'air est aspiré par des moyens propres aux moyens d'affichage. Ainsi, une première cloison (70') divise le volume du caisson en deux parties (701, 702). Une première partie (701) contient, par exemple, les ouvertures (non représentées) d'aération d'arrivée d'air des moyens (21) de visualisation, la deuxième partie (702) contient, par exemple, les ouvertures (non représentées) d'aération de sortie d'air des moyens (21) de visualisation. Le caisson (7) comprend deux deuxièmes cloisons (75) formant un canal (750). La bouche (32) d'entrée d'air débouche dans une première extrémité du canal (750) alors que la deuxième extrémité du canal (750) est connectée sur la première cloison (70'). Ainsi, l'air froid ou frais est guidé directement dans la première partie (701) du caisson (70') contenant les ouvertures (non représentées) d'aération d'arrivée d'air des moyens (21) de visualisation.

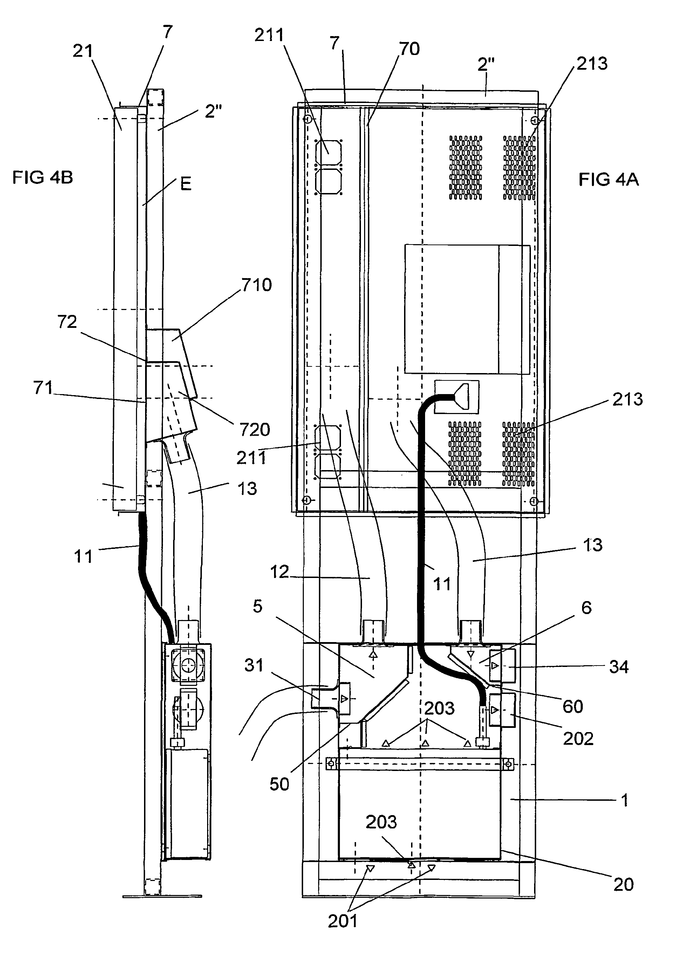

Dans la variante de réalisation représentée aux figures 4A et 4B, le boîtier (2) d'affichage est supprimé et remplacé, par exemple, par un châssis (2") permettant de monter les moyens de visualisation (21) et le boîtier (1) de ventilation. Le boîtier (1) de ventilation est sensiblement identique au boîtier de ventilation décrit en référence à la figure 3. Dans ce cas, le flexible (12), connecté sur la turbine (5) d'aspiration du boîtier (1) de ventilation, est connecté directement sur la première ouverture (71) du caisson, par exemple par l'intermédiaire d'une première boîte (710). Le flexible (13), connecté sur la turbine (6) de refoulement du boîtier (1) de ventilation, est connecté directement sur la deuxième ouverture (72) du caisson (7), par exemple par l'intermédiaire d'une deuxième boîte (720).

Dans cette variante de réalisation les première et deuxième ouvertures (71, 72) du caisson (7) peuvent être pratiquées sur le fond du caisson (7) pour être masquées par la face avant de l'écran (21) à plasma. Cette configuration permet de limiter le nombre de cloisons (70) à l'intérieur du caisson (70). Ainsi, une seule cloison (70) est mise en place pour obtenir deux parties dans le caisson (70). Une première partie (701) contient, par exemple, les ouvertures (211) d'aération d'arrivée d'air des moyens (21) d'affichage, la deuxième partie (702) contient, par exemple, les ouvertures (213) d'aération de sortie d'air des moyens (21) d'affichage. Cette variante de réalisation permet alors de mettre en place un écran à plasma dans une espace confiné où l'arrière de l'écran est disponible, et réduit sans risque de détérioration de l'écran à plasma.

Ainsi, on conçoit qu'en mettant en place des moyens permettant de créer un flux d'air forcé pour refroidir l'écran plasma, il soit possible d'installer un écran plasma dans un espace confiné sans générer une surchauffe de l'écran. De plus, en déportant les moyens d'alimentation et les moyens permettant de créer un flux d'air forcé, le volume nécessaire pour installer un écran plasma est réduit au minimum et correspond sensiblement au volume de l'écran à plasma.

Ainsi, le moniteur d'affichage selon l'invention se caractérise en ce que les moyens de visualisation (21) sont logés dans un caisson (7), les moyens (21) de visualisation sont refroidis par des moyens déportés (5,6) logés dans un boîtier (20) distinct du caisson (7) et connecté au caisson (7) pour assurer une circulation d'air forcée dans le caisson (7) effectuant le refroidissement des moyens (21) de visualisation.

Dans un mode particulier de réalisation, le caisson (7) comprend une première ouverture (71) constituant une arrivée d'air forcé, une deuxième ouverture (72) constituant une sortie d'air forcé, et au moins une cloison (70, 73, 74) de séparation, disposée de sorte que l'air frais entrant ne se mélange pas dans le caisson (7) avec l'air réchauffé par les moyens (21) de visualisation et/ou pour guider l'air frais au niveau des éléments les plus chauds des moyens (21) de visualisation.

Dans un mode particulier de réalisation, les moyens déportés (5,6) permettant d'assurer une circulation d'air de refroidissement sont reliés par des flexibles (12, 13) au caisson (7) contenant les moyens de visualisation pour générer une circulation d'air dans les moyens (21) de visualisation par l'intermédiaire des ouvertures (211, 213) d'aération des moyens (21) de visualisation.

Dans un mode particulier de réalisation, le dispositif (20) d'alimentation est logé dans un boîtier (1) de ventilation comportant également les moyens déportés comportant un dispositif d'aspiration d'air (13) et un dispositif de refoulement d'air (12) qui alimentent le trajet de circulation d'air (32, 40, 33) du caisson (7).

Dans un mode particulier de réalisation, le caisson (7) est logé dans un boîtier (2) d'affichage distinct, déporté par rapport au dispositif d'alimentation.

Dans un mode particulier de réalisation, le boîtier d'affichage (2) comprend une cloison (40) disposée de part et d'autre d'une bouche d'entrée d'air (32) disposée dans le boîtier d'affichage (2) et d'une bouche de sortie d'air (33) disposée dans le boîtier d'affichage (2), de sorte que l'entrée d'air (71) du caisson soit située dans le volume du boîtier (2) d'affichage contenant la bouche d'entrée d'air (32) et que la sortie (72) du caisson (7) soit située dans le volume du boîtier (2) d'affichage contenant la bouche de sortie d'air (33).

Dans un mode particulier de réalisation, les moyens (21) de visualisation comprennent un écran plasma, un écran TFT ou un écran CRT ou un écran numérique.

Dans un mode particulier de réalisation, les moyens d'aspiration (5) et les moyens (6) d'extraction d'air comprennent chacun une turbine montée dans le boîtier de ventilation.

Dans un mode particulier de réalisation, les moyens déportés comprennent des moyens de refroidissement de l'air ambiant avant leur envoi vers le caisson.

Dans un mode particulier de réalisation, le dispositif (20) d'alimentation électrique est monté dans un compartiment (200) d'un boîtier de ventilation comprenant également des moyens (201 à 203) de refroidissement du dispositif d'alimentation.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

## Revendications

1. Moniteur d'affichage comprenant des moyens (21) de visualisation digitaux comportant des ouvertures (211, 213) d'aération et monté dans un boîtier d'affichage (2) constituant un confinement, le moniteur d'affichage comportant un dispositif (20) d'alimentation délivrant des signaux vidéo aux moyens (21) de visualisation, **caractérisé en ce que** les moyens de visualisation (21) sont logés dans un caisson (7), un boîtier de ventillation (1) distinct du caisson (7) est connecté au caisson (7) et des moyens déportés (5, 6) par rapport au boîtier d'affichage (2) sont prévus pour refroidir les moyens (21) de visualisation, les moyens déportés (5,6) étant logés dans le boîtier de ventillation (1) distinct du caisson (7) pour assurer une circulation d'air forcée dans le caisson (7) effectuant le refroidissement des moyens (21) de visualisation.

2. Moniteur d'affichage selon la revendication 1, **caractérisé en ce que** le caisson (7) comprend une première ouverture (71) constituant une arrivée de l'air forcé généré à l'aide des moyens de refroidissement déportés (5, 6), une deuxième ouverture (72) constituant une sortie d'air forcé, et au moins une cloison (70, 73, 74) de séparation disposée de sorte que l'air frais entrant ne se mélange pas dans le caisson (7) avec l'air réchauffé par les moyens (21) de visualisation et/ou pour guider l'air frais au niveau des éléments les plus chauds des moyens (21) de visualisation.

3. Moniteur d'affichage selon la revendication 1 ou 2, **caractérisé en ce que** les moyens déportés (5,6) permettant d'assurer la circulation d'air forcée de refroidissement sont reliés par des flexibles (12, 13) au caisson (7) contenant les moyens (21) de visualisation pour générer une circulation d'air dans les moyens (21) de visualisation par l'intermédiaire des ouvertures (211, 213) d'aération des moyens (21) de visualisation.

4. Moniteur d'affichage selon l'une des revendications 1 à 3, **caractérisé en ce que** le dispositif (20) d'alimentation est logé dans le boîtier de ventilation (1) comportant également les moyens déportés (5, 6) qui comprennent un dispositif d'aspiration d'air (5) et un dispositif de refoulement d'air (6) pour alimenter le trajet de circulation d'air (32, 40, 33) du caisson (7).

5. Moniteur d'affichage des revendications 1 à 4, **caractérisé en ce que** le caisson (7) est logé dans le boîtier (2) d'affichage distinct et déporté par rapport au dispositif (20) d'alimentation.

6. Moniteur d'affichage selon la revendication 5, **caractérisé en ce que** le boîtier d'affichage (2) comprend une cloison (40) disposée de part et d'autre d'une bouche d'entrée d'air (32) disposée dans le boîtier d'affichage (2) et d'une bouche de sortie d'air (33) disposée dans le boîtier d'affichage (2), de sorte que l'entrée d'air (71) du caisson soit située dans le volume du boîtier (2) d'affichage contenant la bouche d'entrée d'air (32) et que la sortie (72) du caisson (7) soit située dans le volume du boîtier (2) d'affichage contenant la bouche de sortie d'air (33).

7. Moniteur d'affichage selon l'une des revendications 1 à 6, **caractérisé en ce que** les moyens (21) de visualisation comprennent un écran plasma, un écran TFT ou un écran CRT ou un écran numérique.

8. Moniteur d'affichage selon la revendication 4, dans lequel le dispositif d'aspiration d'air (5) et le dispositif de refoulement d'air (6) comprennent chacun une turbine montée dans le boîtier de ventilation (1).

9. Moniteur d'affichage selon la revendication 4 ou 8, **caractérisé en ce que** les moyens déportés (5, 6) comprennent des moyens de refroidissement de l'air ambiant avant leur envoi vers le caisson (7).

10. Moniteur d'affichage selon l'une des revendications 1 à 9, **caractérisé en ce que** le dispositif (20) d'alimentation électrique est monté dans un compartiment (200) d'un boîtier de ventilation (1) comprenant également des moyens (201 à 203) de refroidissement du dispositif (20) d'alimentation.

11. Moniteur d'affichage selon l'une des revendications 1 à 3, dans lequel les moyens de refroidissement déportés (5, 6) comportent un dispositif d'aspiration d'air (5) et un dispositif de refoulement d'air (6) montés dans un même boîtier (51) doté d'une bouche (31) d'aspiration d'air frais et d'une bouche (34) de refoulement d'air chaud.

12. Moniteur d'affichage comprenant des moyens (21) de visualisation digitaux, le moniteur d'affichage comportant un dispositif (20) d'alimentation délivrant des signaux vidéo aux moyens (21) de visualisation et des moyens de refroidissement (5, 6, 12', 13') pour refroidir les moyens (21) de visualisation, **caractérisé en ce que** les moyens (21) de visualisation sont logés avec le dispositif (20) d'alimentation dans un boîtier (2') d'habillage, le moniteur d'affichage comprenant :
- un volume (200') dans le boîtier (2') d'habillage pour loger les moyens refroidissement (5, 6, 12', 13') qui génèrent une circulation d'air forcée et comprennent pour cela un dispositif d'aspiration d'air et un dispositif de refoulement d'air,
- un flexible (31) connecté par une extrémité au dispositif d'aspiration d'air (5), et dont l'autre extrémité est libre et déportée par rapport au boîtier d'habillage (2'), et
- un flexible (34) connecté par une extrémité au dispositif de refoulement d'air (6), et dont l'autre extrémité est libre et déportée par rapport au boîtier d'habillage (2').

## Claims

1. Display monitor comprising digital display means (21) including ventilation openings (211, 213) and mounted in a display housing (2) forming a containment, the display monitor including a supply device (20) which delivers video signals to the display means (21), **characterised in that** the display means (21) are housed in a casing (7), a ventilation housing (1) separate from the casing (7) is connected to the casing (7) and means (5, 6) which are offset with respect to the display housing (2) are provided in order to cool the display means (21), the offset means (5, 6) being housed in the ventilation housing (1) separate from the casing (7) in order to ensure forced air circulation in the casing (7) providing cooling of the display means (21).

2. Display monitor as claimed in Claim 1, **characterised in that** the casing (7) comprises a first opening (71) forming an inlet for the forced air generated with the aid of the offset cooling means (5, 6), a second opening (72) forming a forced air outlet, and at least one separating partition disposed in such a way that the fresh air coming in does not mix in the casing (7) with the air heated by the display means (21) and/or in order to guide the fresh air in the region of the hottest elements of the display means (21).

3. Display monitor as claimed in either Claim 1 or Claim 2, **characterised in that** the offset means (5, 6) which make it possible to ensure the forced air circulation for cooling are connected by flexible lines (12, 13) to the casing (7) containing the display means (21) in order to generate an air circulation in the display means (21) via the ventilation openings (211, 213) of the display means (21).

4. Display monitor as claimed in any one of Claims 1 to 3, **characterised in that** the supply device (20) is housed in the ventilation housing (1) also including the offset means (5, 6) which comprise an air intake device (5) and an air discharge device (6) in order to supply the air circulation path (32, 40, 33) of the casing (7).

5. Display monitor as claimed in any one of Claims 1 to 4, **characterised in that** the casing (7) is housed in the separate display housing (2) and offset with respect to the supply device (20).

6. Display monitor as claimed in Claim 5, **characterised in that** the display housing (2) comprises partition (40) disposed on wither side of an air inlet (32) disposed in the display housing (2) and of an air outlet (33) disposed in the display housing (2), such that the air inlet (71) of the casing is situated in the volume of the display housing (29) containing the air inlet (32) and that the outlet (72) of the casing (7) is situated in the volume of the display housing (2) containing the air outlet (33).

7. Display monitor as claimed in any one of Claims 1 to 6, **characterised in that** the display means comprise a plasma screen, a TFT screen or a CRT screen or a digital screen.

8. Display monitor as claimed in Claim 4, in which the air intake device (5) and the air discharge device (6) each comprise a turbine mounted in the ventilation housing (1).

9. Display monitor as claimed in either Claim 4 or Claim 8, **characterised in that** the offset means (5, 6) comprise means for cooling the ambient air before it is sent towards the casing (7).

10. Display monitor as claimed in any one of Claims 1 to 9, **characterised in that** the electrical supply device (20) is mounted in a compartment (200) of a ventilation housing (1) also comprising means (201 to 203) for cooling the supply device (20).

11. Display monitor as claimed in any one of Claims 1 to 3, in which the offset cooling means (5, 6) include an air intake device (5) and an air discharge device (6) which are mounted in one and the same housing (51) provided with a fresh air intake (31) and a hot air discharge (34).

12. Display monitor comprising digital display means (21), the display monitor including a supply device (20) which delivers video signals to the display means (21), and cooling means (5, 6, 12' 13') for cooling the display means (21), **characterised in that** the display means (21) are housed with the supply device (20) in an outer housing (2'), the display monitor comprising:
- a volume (200') in the outer housing (2') to house the cooling means (5, 6, 12', 13') which generate a forced air circulation and comprise for this purpose an air intake device and an air discharge device,
- a flexible line (31) connected by one end to the air intake device (5), and of which the other end is free and offset with respect to the outer housing (2'), and
- a flexible line (34) connected by one end to the air discharge device (6), and of which the other end is free and offset with respect to the outer housing (2').

## Patentansprüche

1. Anzeigebildschirm, der digitale Visualisierungsmittel (21) mit Lüftungsöffnungen (211, 213) aufweist und in einem Anzeigegehäuse (2) montiert ist, das eine Umgrenzung bildet, wobei der Anzeigebildschirm eine Versorgungseinrichtung (20) aufweist, die Videosignale an die Visualisierungsmittel (21) ausgibt, **dadurch gekennzeichnet, dass** die Visualisierungsmittel (21) in einem Kasten (7) aufgenommen sind, ein Lüftergehäuse (1), das sich von dem Kasten (7) unterscheidet, an den Kasten (7) angeschlossen ist, und Mittel (5, 6), die relativ zu dem Anzeigegehäuse (2) versetzt sind, zum Kühlen der Visualisierungsmittel (21) vorgesehen sind, wobei die versetzten Mittel (5, 6) in dem sich von dem Kasten unterscheidenden Lüftergehäuse (1) zum Sicherstellen einer erzwungenen, das Kühlen der Visualisierungsmittel (21) bewirkenden Luftzirkulation in dem Kasten aufgenommen sind.

2. Anzeigebildschirm gemäß Anspruch 1, **dadurch gekennzeichnet, dass** der Kasten (7) aufweist: eine erste Öffnung (71), die einen Eintritt für die Zwangsluft bildet, die mit Hilfe der versetzten Kühlmittel (5, 6) erzeugt wird, eine zweite Öffnung (7), die einen Auslass für die Zwangsluft bildet, und mindestens eine Trennwand (70, 73, 74), die derart angeordnet ist, dass die eintretende kühle Luft sich nicht in dem Kasten (7) mit der Luft vermischt, die von den Visualisierungsmitteln (21) erwärmt wurde, und/oder zum Führen der kühlen Luft auf die Ebene der wärmsten Elemente der Visualisierungsmittel (21).

3. Anzeigebildschirm gemäß Anspruch 1 oder 2, **dadurch gekennzeichnet, dass** die versetzten Mittel (5, 6), die das Sicherstellen der erzwungenen Luftzirkulation zum Kühlen ermöglichen, durch biegsame Verbindungsstücke (12, 13) an den Kasten (7) angeschlossen sind, der die Visualisierungsmittel (21) enthält, zum Erzeugen einer Luftzirkulation in den Visualisierungsmitteln (21) durch Öffnungen (211, 213) zum Belüften der Visualisierungsmittel (21).

4. Anzeigebildschirm gemäß einem der Ansprüche 1 bis 3, **dadurch gekennzeichnet, dass** die Versorgungseinrichtung (20) in dem Lüftergehäuse (1) angeordnet ist, das auch die versetzten Mittel (5, 6) aufweist, die eine Vorrichtung (5) zum Ansaugen von Luft und eine Vorrichtung (6) zum Verdrängen von Luft aufweisen zum Speisen des Luftzirkulationsweges (32, 40, 33) des Kastens (7).

5. Anzeigebildschirm der Ansprüche 1 bis 4, **dadurch gekennzeichnet, dass** der Kasten (7) in dem gesonderten Anzeigegehäuse (2) angeordnet ist und relativ zu der Versorgungseinrichtung (20) versetzt ist.

6. Anzeigebildschirm gemäß Anspruch 5, **dadurch gekennzeichnet, dass** das Anzeigegehäuse (2) eine Trennwand (40) aufweist, die auf einer Seite einer in dem Anzeigegehäuse (2) angeordneten Luft-Eintrittsöffnung (32) beziehungsweise auf der anderen Seite einer in dem Anzeigegehäuse (2) angeordneten Luft-Austrittsöffnung (33) positioniert ist, so dass der Lufteinlass (71) des Kastens in dem Volumen des Anzeigegehäuses (2) positioniert ist, das die Lufteintrittsöffnung (32) enthält, und der Auslass (72) des Kastens in dem Volumen des Anzeigegehäuses (2) positioniert ist, das die Luftauslassöffnung (33) enthält.

7. Anzeigebildschirm gemäß einem der Ansprüche 1 bis 6, **dadurch gekennzeichnet, dass** die Visualisierungsmittel (21) einen Plasmabildschirm, einen TFT-Bildschirm oder einen CRT-Bildschirm oder einen digitalen Bildschirm aufweisen.

8. Anzeigebildschirm gemäß Anspruch 4, wobei die Luftansaugvorrichtung (5) und die Luftverdrängungsvorrichtung (6) jeweils eine Turbine aufweisen, die in dem Lüftergehäuse (1) montiert ist.

9. Anzeigebildschirm gemäß Anspruch 4 oder 8, **dadurch gekennzeichnet, dass** die versetzten Mittel (5, 6) Mittel zum Kühlen der Umgebungsluft vor deren Liefern an den Kasten (7) aufweisen.

10. Anzeigebildschirm gemäß einem der Ansprüche 1 bis 9, **dadurch gekennzeichnet, dass** die Vorrichtung (20) zur elektrischen Versorgung in einer Kammer (200) eines Lüftergehäuses (1) montiert ist, die ebenfalls Mittel (201 bis 203) zum Kühlen der Versorgungseinrichtung (20) aufweist.

11. Anzeigebildschirm gemäß einem der Ansprüche 1 bis 3, wobei die versetzten Kühlmittel (5, 6) aufweisen: eine Vorrichtung (5) zum Ansaugen von Luft und eine Vorrichtung (6) zum Verdrängen von Luft, die in demselben Gehäuse (51) montiert sind, das eine Öffnung (31) zum Ansaugen von kühler Luft und eine Öffnung (34) zum Verdrängen von warmer Luft aufweist.

12. Anzeigebildschirm, der digitale Visualisierungsmittel (21) aufweist, wobei der Anzeigebildschirm aufweist: eine Versorgungseinrichtung (20), die Videosignale an die Visualisierungsmittel (21) ausgibt, und Kühlmittel (5, 6, 12', 13') zum Kühlen der Visualisierungsmittel (21), **dadurch gekennzeichnet, dass** die Visualisierungsmittel (21) mit der Versorgungseinrichtung (20) in einem Ummantelungsgehäuse (2') angeordnet sind, wobei der Anzeigebildschirm aufweist:
- ein Volumen (200') in dem Ummantelungsgehäuse (2') zum Aufnehmen der Kühlmittel (5, 6, 12', 13'), die eine erzwungene Luftzirkulation erzeugen und hierzu eine Luftansaugvorrichtung und eine Luftverdrängungsvorrichtung aufweisen,
- ein biegsames Verbindungsstück (31), das mit einem Ende an die Luftansaugvorrichtung (5) angeschlossen ist und dessen anderes Ende frei ist und relativ zu dem Ummantelungsgehäuse (2') versetzt ist, und
- ein biegsames Verbindungsstück (34), das mit einem Ende an die Luftverdrängungsvorrichtung (6) angeschlossen ist, und dessen anderes Ende frei ist und relativ zu dem Ummantelungsgehäuse (2') versetzt ist.
